# EUROPEAN PATENT APPLICATION

(11) **EP 2 075 350 A2**
(43) Date of publication of application: **01.07.2009**
(21) Application number: 08171322.4
(22) Date of filing: 11.12.2008
(51) Int. Cl.: C22C 29/08

(54) **CVD coated cutting tool insert for milling**

(30) Priority: 27.12.2007 SE 0702865
(71) Applicant: Seco Tools AB, 737 82 Fagersta (SE)
(72) Inventor: Larsson, Andreas, SE-737 47 Fagersta (SE); Zackrisson, Jenni, SE-737 88 Fagersta (SE)
(74) Representative: Hägglöf, Henrik

(57) **Abstract**

The present invention relates to a coated cemented carbide milling tool insert comprising a cemented carbide body and a coating. The cemented carbide body has a composition of 7-15 wt% Co, cubic carbonitride phase and WC with a surface zone with a thickness of at least 5 µm which is binder phase enriched and essentially free of cubic carbonitride phase and a wear resistant coating comprising at least one layer of Al₂O₃ with a thickness of 1-15 µm.

## Description

The present invention relates to a coated cemented carbide cutting tool insert for milling applications in which a combination of high wear resistance and good toughness properties are required. The insert has a body with a tough Co binder phase, WC and cubic carbonitrides as hard phases and a wear resistant coating comprising an Al₂O₃ layer. The surface zone of the insert body is of a different elemental composition than that of the bulk, giving the inserts enhanced properties.

During milling of various materials with coated cemented carbide cutting tools, the cutting edges are regarded as being worn according to different wear mechanisms. Wear types such as chemical wear, abrasive wear and adhesive wear, are rarely encountered in a pure state, and complex wear patterns are often the result. The domination of any of the wear mechanisms is determined by the application, and is dependent on properties of the machined material, applied cutting parameters and the properties of the tool material. In general, it is very difficult to improve all tool properties simultaneously, and particularly, edge toughness and wear resistance are difficult to combine, and commercial cemented carbide grades have usually been optimised with respect to one or few of the above mentioned wear types, and have consequently been optimised for specific application areas.

US 6,062,776 discloses a coated cutting insert particularly useful for milling of low and medium alloyed steels and stainless steels with raw surfaces such as cast skin, forged skin, hot or cold rolled skin or pre-machined surfaces under unstable conditions. The insert is characterised by a WC-Co cemented carbide with a low content of cubic carbides and a rather low W-alloyed binder phase and a coating including an innermost layer of TiCₓN_{y}O_{z} with columnar grains and a top layer of TiN and an inner layer of κ-Al₂O₃.

US 6,177,178 describes a coated milling insert particularly useful for milling in low and medium alloyed steels with or without raw surface zones during wet or dry conditions. The insert is characterised by a WC-Co cemented carbide with a low content of cubic carbides and a highly W-alloyed binder phase and a coating including an inner layer of TiCₓN_{y}O_{z} with columnar grains, an inner layer of κ-Al₂O₃ and, preferably, a top layer of TiN.

US 6,250,855 discloses a coated milling insert for wet or dry milling of stainless steels of different composition and microstructure. The coated WC-Co based cemented carbide inserts includes a specific composition range of WC-Co without any additions of cubic carbides, a low W-alloyed Co binder and a hard and wear resistant coating including a multilayered structure of sublayers of the composition (TiₓAl₁₋ₓ)N.

EP 1103635 provides a cutting tool insert particularly useful for wet and dry milling of low and medium alloyed steels and stainless steels as well as for turning of stainless steels. The cutting tool is comprised of a cobalt cemented carbide substrate with a multi-layer refractory coating thereon. The substrate has a cobalt content of 9.0-10.9 wt% and contains 1.0-2.0 wt% TaC/NbC. The coating consists of an MTCVD TiCₓN_{y}O_{z} layer and a multi-layer coating being composed of κ-Al₂O₃ and TiCₓN_{y}O_{z} layers.

EP 1493845 relates to a coated cemented carbide insert (cutting tool), particularly useful for milling of stainless steels and super alloys but also milling of steels in toughness demanding applications. The cutting tool insert is characterised by a cemented carbide body comprising WC, NbC and TaC, a W-alloyed Co binder phase, and a coating comprising an innermost layer of TiCₓN_{y}O_{z} with equiaxed grains, a layer of TiCₓN_{y}O_{z} with columnar grains and a layer of a-Al₂O₃.

EP 1352697 provides coated cemented carbide inserts (cutting tool), particularly useful for milling at high cutting speeds in steels and milling in hardened steels. The inserts are characterised by a WC-Co cemented carbide containing NbC and TaC and a W-alloyed binder phase and a coating including a first, innermost layer of TiCₓN_{y}O_{z} with equiaxed grains, a layer of TiCₓN_{y}O_{z} with columnar grains and at least one layer of Al₂O₃ consisting essentially of the κ-phase.

EP 1026271 relates to a coated cemented carbide insert for turning of steels. The insert has a highly alloyed Co-binder phase, 4-12, preferably 7-10, percent by weight of cubic carbides and a WC grain size of 1-4, preferably 2-3 µm. The binder phase enriched surface zone is of a thickness <20 µm and along a line in the direction from the edge to the centre of the insert the binder phase content increases essentially monotonously until it reaches the bulk composition. The coating of the insert comprises 3-12 µm of columnar TiCN and 2-12 µm of Al₂O₃.

EP 1348779 relates to a cutting tool insert consisting of a cemented carbide substrate and a coating. The cemented carbide substrate comprises WC, 4-7 wt% cobalt, 6-9 wt% cubic carbide forming metals from the groups IVb and Vb, with a binder phase enriched surface zone with a thickness of>20 µm and the total thickness of the coating being less than 30 µm. Inserts according to the invention exhibit favourable wear resistance and edge strength when turning steel.

EP 1528125 relates to a cutting tool insert for rough turning composed of a cemented carbide and a coating. The cemented carbide substrate comprises WC, 7-12 wt-% Co, 5-11 wt-% cubic carbides of metals from the groups IVb, Vb and VIb with a binder phase enriched surface zone. The tungsten carbide phase has a mean intercept length of 0.7-1.4 µm. The coating comprises at least one α-Al₂O₃.

US 2008/187775 relates to a turning cutting tool insert comprising a cemented carbide body and a coating. The cemented carbide body comprises WC, 6-7 wt-% Co and 6-10, wt-% cubic carbides of the metals from groups IVb, Vb and VIb of the periodic table, preferably Ti, Nb and Ta, and at least one surface of the cemented carbide body comprises a binder phase enriched surface zone being essentially free from cubic carbides and a coating wherein at least one layer is a 5-7 µm thick α-Al₂O₃ layer with a (104) texture.

EP 1469101 relates to a coated cemented carbide cutting tool insert particularly useful for turning of cast irons but also low alloyed steels at mediate to high cutting speeds. The cutting tool insert is characterised by a cemented carbide body comprising WC, cubic carbonitrides, a W-alloyed Co binder phase, a surface zone of the cemented carbide body that is binder phase enriched and nearly free of cubic carbonitride phase, and a coating including an innermost layer of TiCₓN_{y}O_{z} with equiaxed grains, a layer of TiCₓN_{y}O_{z} with columnar grains and at least one layer of Al₂O₃.

EP 1531187 concerns a coated cemented carbide cutting tool insert particularly useful for turning of cast irons. The cutting tool insert is characterised by a cemented carbide body comprising WC, cubic carbonitrides, a W-alloyed Co binder phase, a surface zone of the cemented carbide body that is binder phase enriched and nearly free of cubic carbonitride phase, and a coating including an innermost layer of TiCₓN_{y}O_{z} with equiaxed grains, a layer of TiCₓN_{y}O_{z} with columnar grains and at least one layer of Al₂O₃.

EP 1314790 relates to a cutting tool insert consisting of a cemented carbide substrate and a coating. The cemented carbide substrate comprises 73-93% by weight WC, 4-12% by weight binder phase, and cubic carbide phase with a binder phase enriched surface zone essentially free of cubic carbide phase. The cubic carbide phase comprises of elements from the groups IVb and Vb, with the tantalum content on a level corresponding to a technical impurity. Inserts according to the invention exhibit favourable edge strength and thermal shock resistance.

It is an objective of the present invention to provide a coated cutting tool with enhanced performance for milling.

The milling cutting tool insert according to the present invention has a body with a tough Co binder phase, WC and cubic carbonitrides as hard phases and a wear resistant coating comprising an Al₂O₃ layer. The surface zone of the insert body is of a different elemental composition than that of the bulk, giving the inserts enhanced properties.

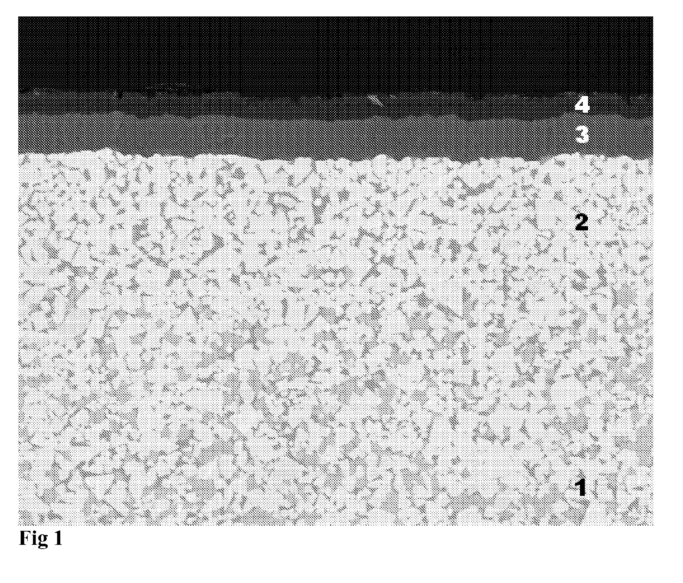

Fig 1 shows in 1000X the structure of the milling tool insert according to the invention in which
1. Cemented carbide bulk
2. Cemented carbide surface zone
3. A layer consisting of a cubic carbonitride
4. A layer consisting of Al₂O₃.

According to the present invention, a coated milling tool insert is provided with a cemented carbide body having a composition of 7-15, preferably 8-13, most preferably 9-12, wt% Co, cubic carbonitride phase and WC and a wear resistant coating comprising at least one layer of Al₂O₃, preferably of the α-phase, said layer with a thickness of 1-15 µm. The surface zone of the insert body is of a different elemental composition than that of the bulk, giving the insert enhanced properties. The surface zone has a thickness of at least 5 µm and is binder phase enriched and essentially free of cubic carbonitride phase.

In a first preferred embodiment, the amount of cubic carbonitrides corresponds to 1.5-25.0% by weight of the cubic carbonitride forming elements from groups IVb, Vb and VIb of the periodic table, preferably 3.0-15.0% by weight.

In a second preferred embodiment, the cubic carbonitride forming elements are titanium, tantalum, niobium, zirconium, hafnium, vanadium and/or chromium.

In a third preferred embodiment, the amount of cubic carbonitrides corresponds to 1.5-25.0% by weight of the cubic carbonitride forming elements titanium, tantalum and niobium, preferably 3.0-15.0% by weight. The ratio between tantalum and niobium is within 0.8-4.5 by weight, preferably 1.2-3.0 by weight. The ratio between titanium and niobium is within 0.5-7.0 by weight, preferably 1.0-4.0 by weight.

In a fourth preferred embodiment, the Co enrichment in the surface zone is within 1.2-3.0 times the bulk Co content.

In a fifth preferred embodiment, particularly for cast iron applications, the Co content is 7-10 wt%, preferably 7-9 wt%.

In a sixth preferred embodiment, particularly for cast iron applications, the Co content is 7-10 wt%, preferably 7-9 wt%.

In a seventh preferred embodiment, the hard wear resistant coating comprises a layer of cubic carbonitride in the form of TiCₓN_{y}O_{z} and a layer of a metal oxide in the form of Al₂O₃ with a total coating thickness of 2-20 µm.

Furthermore, the mean intercept length of the tungsten carbide phase measured on a ground and polished representative cross section is in the range 0.3-1.0 µm, preferably 0.4-0.9 µm. The intercept length is measured by means of image analysis on micrographs with a magnification of 10000x and calculated as the average mean value of approximately 1000 intercept lengths.

The present invention also relates to a method of making a coated milling tool comprising
- providing a cemented carbide body having a composition of 7-15, preferably 8-13, most preferably 9-12, wt% Co, cubic carbonitride phase and WC with a mean intercept length of 0.3-1.0 µm, preferably 0.4-0.9 µm with a surface zone with a thickness of at least 5 µm which is binder phase enriched and essentially free of cubic carbonitride phase using conventional powder metallurgical methods, milling pressing and sintering. The desired mean intercept length depends on the grain size of the starting powders and milling and sintering conditions and has to be determined by experiments and
- depositing a wear resistant coating comprising at least one layer of Al₂O₃, preferably of the α-phase, with a thickness of 1-15 µm using CVD methods known in the art.

The invention also relates to the use of cutting tool inserts according to the above for milling of cast irons, steels and stainless steels at cutting speeds of 50-500 m/min, preferably 75-400 m/min, with an average feed per tooth of 0.08-0.5 mm, preferably 0.1-0.4 mm depending on cutting speed and insert geometry.

### Example 1.

Grade A: A cemented carbide substrate in accordance with the invention with the composition 8 wt% Co, 2.0 wt% Ta, 0.9 wt% Nb, 1.5 wt% Ti, balance W, C and N, was produced by conventional milling of powders, pressing of green compacts and subsequent sintering at 1430°C. Investigation of the microstructure after sintering showed that the mean intercept length of the tungsten carbide phase was 0.62 µm and that the surface zone of the inserts consisted of a 20 µm thick binder phase enriched part nearly free of cubic carbonitride phase. The substrate was coated in accordance with the invention with subsequent layers deposited during the same coating cycle. The first layer was a 0.2 µm thick TiCₓN_{y}O_{z} layer with z<0.1 and y>0.6, having equiaxed grains. The second layer was 4 µm of columnar TiCₓN_{y}O_{z} deposited at about 850°C with acetonitrile as carbon and nitrogen source, yielding an approximated carbon to nitrogen ratio x/y=1.5 with z<0.1. A 5 µm thick layer of Al₂O₃, consisting of the α-phase, was deposited at approximately 1000°C.

Grade B: A cemented carbide substrate in accordance with the invention with the composition 8 wt% Co, 2.0 wt% Ta, 0.9 wt% Nb, 1.5 wt% Ti, 0.25 wt% Cr, balance W, C and N, was produced according to grade A. Investigation of the microstructure after sintering showed that the mean intercept length of the tungsten carbide phase was 0.58 µm and that the surface zone of the inserts consisted of a 22 µm thick binder phase enriched part nearly free of cubic carbonitride phase. The substrate was coated in accordance with Grade A.

Grade C: A cemented carbide substrate in accordance with the invention with the composition 8 wt% Co, 2.0 wt% Ta, 0.9 wt% Nb, 1.0 wt% Ti, 0.3 wt% Zr, balance W, C and N, was produced according to grade A. Investigation of the microstructure after sintering showed that the mean intercept length of the tungsten carbide phase was 0.59 µm and that the surface zone of the inserts consisted of a 23 µm thick binder phase enriched part nearly free of cubic carbonitride phase. The substrate was coated in accordance with Grade A.

Grade D: A cemented carbide substrate in with the composition 8 wt% Co, 1.3 wt% TaC, 0.2 wt% NbC and balance WC. Investigation of the microstructure after sintering showed that the mean intercept length of the tungsten carbide phase was 0.63 µm and that the average phase composition was representative throughout the sintered body. The substrate was coated in accordance with Grade A.

Inserts according to Grade A, B, C and D were tested in a face milling application where coolant was applied.

| Operation | Face milling |
|---|---|
| Cutter diameter | 225 mm |
| Work piece | Cylinder block |
| Material | SS0125 |
| Insert type | ONMF090520ANTN-M14 |
| Cutting speed | 150 m/min |
| Feed | 0.25 mm/tooth |
| Coolant | Yes |
| | |

| Results | Tool life (components) |
|---|---|
| Grade A (according to invention) | 580 |
| Grade B (according to invention) | 620 |
| Grade C (according to invention) | 600 |
| Grade D | 550 |

The tool life was limited by the combination of flank wear, chipping and thermal cracking. The test shows the improved wear resistance and toughness was achieved with a binder phase enriched surface zone.

### Example 2.

Grade E: A cemented carbide substrate in accordance with the invention with the composition 10 wt% Co, 3.0 wt% Ta, 2.0 wt% Nb, 2.0 wt% Ti, balance W, C and N, was produced by conventional milling of powders, pressing of green compacts and subsequent sintering at 1430°C. Investigation of the microstructure after sintering showed that the mean intercept length of the tungsten carbide phase was 0.78 µm and that the surface zone of the inserts consisted of a 20 µm thick binder phase enriched part nearly free of cubic carbonitride phase. The substrate was coated in accordance with the invention with subsequent layers deposited during the same coating cycle. The first layer was a 0.2 µm thick TiCₓN_{y}O_{z} layer with z<0.1 and y>0.6, having equiaxed grains. The second layer was 3 µm of columnar TiCₓN_{y}O_{z} deposited at about 850°C with acetonitrile as carbon and nitrogen source, yielding an approximated carbon to nitrogen ratio x/y=1.5 with z<0.1. A 3 µm thick layer of Al₂O₃, consisting of the α-phase, was deposited at approximately 1000°C.

Grade F: A cemented carbide substrate in accordance with the invention with the composition 10 wt% Co, 3.0 wt% Ta, 2.0 wt% Nb, 1.5 wt% Ti, 0.4 wt% Zr, balance W, C and N, was produced according to grade A. Investigation of the microstructure after sintering showed that the mean intercept length of the tungsten carbide phase was 0.76 µm and that the surface zone of the inserts consisted of a 18 µm thick binder phase enriched part nearly free of cubic carbonitride phase. The substrate was coated in accordance with Grade E.

Grade G: A cemented carbide substrate with the composition 10 wt% Co, 1.3 wt% TaC, 0.2 wt% NbC and balance WC. Investigation of the microstructure after sintering showed that the mean intercept length of the tungsten carbide phase was 0.80 µm and that the average phase composition was representative throughout the sintered body. The substrate was coated in accordance with Grade F.

Inserts according to Grade E, F and G were tested in a face milling application of a steel component.

| Operation | Face milling |
|---|---|
| Cutter diameter | 63 mm |
| Material | SS 2244 |
| Insert type | SEMX1204AFTN-M15 |
| Cutting speed | 300 m/min |
| Feed | 0.3 mm/tooth |
| Depth of cut | 3 mm |
| Width of cut | 50 mm |
| Coolant | No |
| | |

| Results | Tool life (components) |
|---|---|
| Grade E (according to invention) | 50 |
| Grade F (according to invention) | 43 |
| Grade G | 38 |

The test was stopped at the same maximum flank wear. There was a smaller tendency for edge chipping on Grade E and F compared with Grade G.

## Claims

1. A milling tool insert, comprising a cemented carbide body and a coating **characterised in** said body having a composition of 7-15, preferably 8-13, most preferably 9-12, wt% Co, cubic carbonitride phase and WC with a mean intercept length in the range 0.3-1.0 µm with a surface zone with a thickness of at least 5 µm which is binder phase enriched and essentially free of cubic carbonitride phase, preferably with a Co enrichment in the surface zone within 1.2-3.0 times the bulk Co content and a wear resistant coating comprising at least one layer of Al₂O₃, preferably of the α-phase, said layer with a thickness of 1-15 µm.

2. A milling tool insert according to claim 1 **characterised in that** the amount of cubic carbonitride phase corresponds to 1.5-25.0% by weight, preferably 3.0-15.0% by weight, of the cubic carbonitride forming elements from groups IVb, Vb and VIb of the periodic table.

3. A milling tool insert according to claim 2 **characterised in that** the cubic carbonitride forming elements are titanium, tantalum, niobium, zirconium, hafnium, vanadium and/or chromium.

4. A milling tool insert according to claim 3 **characterised in that** the amount of cubic carbonitrides corresponds to 1.5-25.0% by weight of the cubic carbonitride forming elements titanium, tantalum and niobium, preferably 3.0-15.0% by weight and that the ratio between tantalum and niobium is within 0.8-4.5 by weight, preferably 1.2-3.0 by weight and between titanium and niobium is within 0.5-7.0 by weight, preferably 1.0-4.0 by weight.

5. A milling tool insert according to any of the preceding claims **characterised in that** the Co content is 7-10 wt%, preferably 7-9 wt% for cast iron applications..

6. A milling tool insert according to any of the preceding claims **characterised in that** the Co content is 7-15 wt%, preferably 8-13 wt% for steel and stainless steel applications.

7. A milling tool insert according to any of the preceding claims **characterised in that** the hard wear resistant coating comprises a layer of cubic carbonitride in the form of TiCₓN_{y}O_{z} with a total coating thickness of 2-20 µm.

8. Method of making a coated milling tool insert **characterised in**
- providing a cemented carbide body having a composition of 7-15, preferably 8-13, most preferably 9-12, wt% Co, cubic carbonitride phase and WC with a mean intercept length of 0.3-1.0 µm, preferably 0.4-0.9 µm with a surface zone with a thickness of at least 5 µm which is binder phase enriched and essentially free of cubic carbonitride phase using conventional powder metallurgical methods, milling pressing and sintering and
- depositing a wear resistant coating comprising at least one layer of Al₂O₃, preferably of the α-phase, with a thickness of 1-15 µm using CVD methods known in the art.

9. Use of a cutting tool insert according to claims 1-7 for milling of cast irons, steels and stainless steels at cutting speeds of 50-500 m/min, preferably 75-400 m/min, with an average feed per tooth of 0.08-0.5 mm, preferably 0.1-0.4 mm depending on cutting speed and insert geometry.
